# EUROPEAN PATENT SPECIFICATION

(11) **EP 2 773 804 B1**
(45) Date of publication and mention of the grant of the patent: **14.09.2016**
(21) Application number: 12790450.6
(22) Date of filing: 31.10.2012
(51) Int. Cl.: D06F 39/00, H03K 17/96

(54) **A HOUSEHOLD APPLIANCE COMPRISING A TOUCH BUTTON**
HAUSGERÄT MITDRUCKTASTENSCHALTER
APPAREIL ÉLECTROMÉNAGER COMPRENANT UN BOUTON À TOUCHE

(30) Priority: 04.11.2011 TR 201111064
(43) Date of publication of application: 10.09.2014
(73) Proprietor: Arçelik Anonim Sirketi, 34950 Istanbul (TR)
(72) Inventor: TEZCAN, Safak, 34950 Istanbul (TR); ERCAN, Onur, 34950 Istanbul (TR); ERTAS, Firdevs Basaran, 34950 Istanbul (TR); ACIL, Aykun, 34950 Istanbul (TR)
(86) International application number: PCT/EP2012/071624
(87) International publication number: WO 2013/064572

(56) References cited:
- EP-A1- 1 786 107
- EP-A1- 2 053 745
- EP-A2- 2 161 655

## Description

The present invention relates to a household appliance comprising a touch button situated on the control panel.

Nowadays, household appliances controlled by using touch buttons are preferred because of their ease of use and esthetic appearance. Various methods exist for the touch buttons to detect the contact of the user and detection by means of capacitive change is one of these methods. However, the spring fixed on the circuit board may be deformed due to connection errors that may occur during the assembly of the circuit board on the control panel or of the control panel on the household appliance. In this situation, the plate fixed to the spring cannot be aligned with the designated area on the control panel. As a result, the user cannot control the household appliance in the desired manner by using the control panel.

In the state of the art European Patent Application No. EP1786107, a holder is disclosed which is produced from plastic material and which extends along the spring in a capacitive touch button. It is described that the said holder positions the spring on the circuit board.

A household appliance with the features of the preamble of claim 1 is known from EP 2 053 745 A1.

The aim of the present invention is the realization of a household appliance comprising a touch button which is prevented from being damaged during assembly or transportation and thus provided to have longer life.

The household appliance realized in order to attain the aim of the present invention, explicated in the first claim and the respective claims thereof, comprises a control panel having a designated area for the user to touch, a circuit board having a sensor situated behind the control panel, and a touch button having at least one spring which transmits the capacitive difference that is formed by the touching of the user to the designated area and a plate preferably in circular form, situated between the control panel and the spring and which is mounted to the upper end of the spring, and a guide having at least one housing which surrounds the spring almost without a gap so as to allow the spring to lengthen and shorten therein.

In the household appliance of the present invention, connection errors occurring as a result of the touch button not being aligned with the designated area during assembly are prevented by means of the guide.

In an embodiment of the present invention, the diameter of the spring and of the housing that surrounds the spring are smaller than the diameter of the plate. When moved downwards, the plate is seated on the edge of the housing and does not enter into the housing.

In an embodiment of the present invention, the height of the guide is less than the free height of the spring such that the spring remains partially outside the housing. Thus, the control panel can be easily mounted to the circuit board.

In an embodiment of the present invention, the household appliance comprises a guide having a first support member and a second support member which form the housing when joined so as to sandwich the spring. By means of the guide being formed of two support members, the guide can be fixed on the circuit board so as to surround the spring from below the plate.

In a derivative of this embodiment, slots are arranged on at least one support member which form the housings that surround the springs.

In a derivative of this embodiment, the protrusion situated on the second support member enters into the recess arranged on the first support member. Thus, slots are aligned so as to form the housing.

In a derivative of this embodiment, a resting surface is situated on the first support member and a fixing member on the second support member. In this embodiment, the fixing member engages with the resting surface and thus the support members are provided to be mounted to each other.

In a derivative of this embodiment, the support members are same. Thus, since different moulds are not used for support members, production costs decrease.

In an embodiment of the present invention, an opening is arranged on the circuit board through which the claw which provides the guide to be fixed to the circuit board passes.

In an embodiment of the present invention, the household appliance comprises a hole arranged on the circuit board and at least one pin which provides the claw to reach the level of the opening by passing through the hole. Thus the mounting of the claw to the opening is facilitated.

The model embodiments relating to a household appliance realized in order to attain the aim of the present invention are illustrated in the attached figures, where:

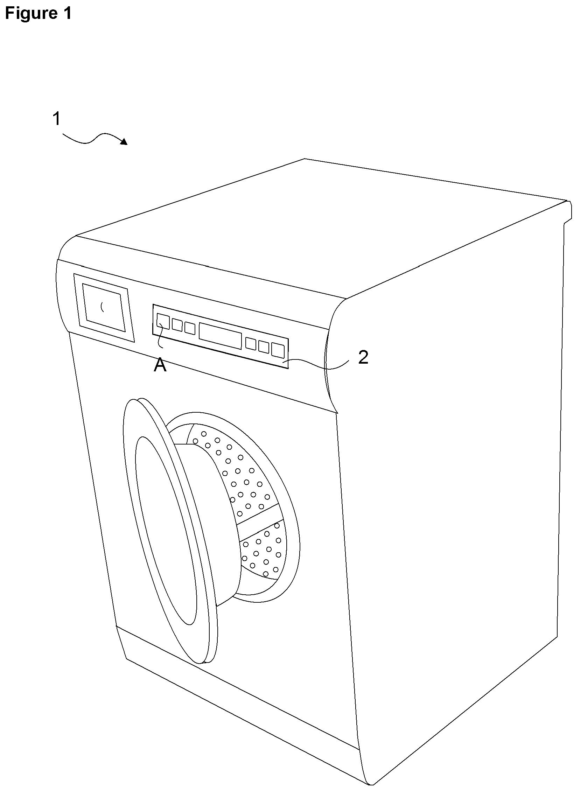

Figure 1 - is the perspective view of a household appliance.
Figure 2 - is the perspective view of a circuit board and the touch buttons.
Figure 3 - is the perspective view of a guide, a circuit board and the touch buttons in an embodiment of the present invention.
Figure 4 - is the perspective view of the support members.

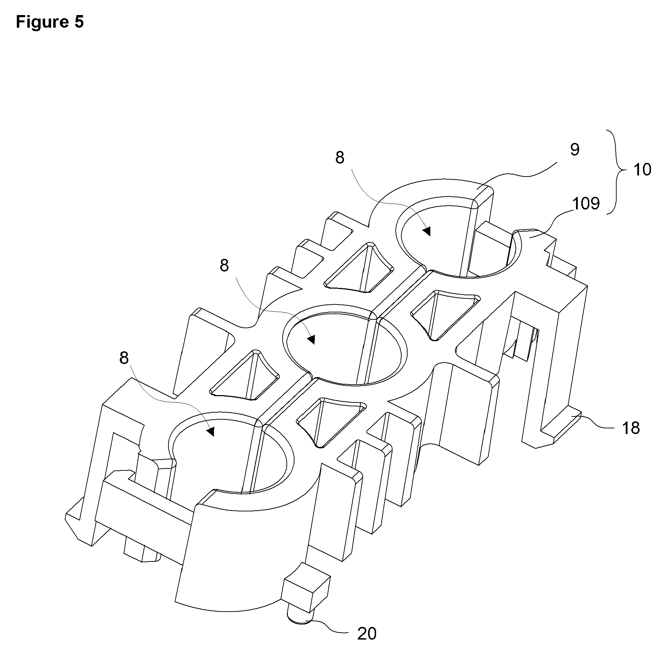

Figure 5 - is the perspective view of a guide.

The elements illustrated in the figures are numbered as follows:
- 1.: Household appliance
- 2.: Control panel
- 3.: Sensor
- 4.: Circuit board
- 5.: Spring
- 6.: Plate
- 7.: Touch button
- 8.: Housing
- 9.: 109. Support member
- 10.: Guide
- 11.: Recess
- 12.: Protrusion
- 13.: Resting surface
- 14.: Fixing member
- 15.: Rib
- 16.: Handle
- 17.: Opening
- 18.: Claw
- 19.: Hole
- 20.: Pin
- 21.: 121. Slot

The household appliance (1) comprises
- a control panel (2) having a designated area (A) thereon which provides the user to select the desired program parameters by touching,
- a circuit board (4) having a sensor (3) situated behind the control panel (2) and
- at least one touch button (7) having at least one spring (5) one end of which is fixed to the circuit board (4) and which transmits to the sensor (3) the capacitive difference that is formed when the designated area (A) is touched and a plate (6) which is fixed to the free end of the spring (5) so as to contact the control panel (2)

### (Figure 1).

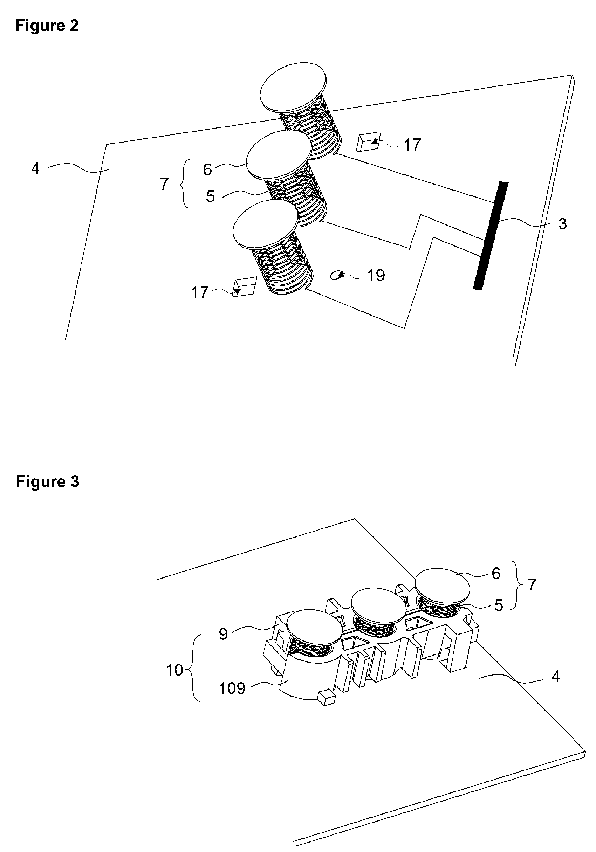

The household appliance (1) of the present invention comprises a guide (10) having a housing (8) that surrounds the spring (5) almost without a gap so as to allow the spring (5) to shorten and lengthen (Figure 3).

When the user moves his/her finger near or touches the designated area (A) on the control panel (2) for touching, a capacitance is formed between the plate (6) and the point where the user moves his/her finger. The electrical effect generated by the capacitance is transmitted to the sensor (3) on the circuit board (4) designed to detect the capacitance difference by means of the spring (5). The end of the spring (5) which is not connected to the circuit board (4) is connected to the plate (6) and the plate (6) on the control panel (2) is almost as large as the designated area (A) for the user to touch. The circuit board (4) determines the command entered by the user according to the change information received from the sensor (3) and operates the functions of the household appliance (1) in compliance with these commands.

The diameter of the housing (8) is sized to be approximately same as the maximum outer diameter of the spring (5) or is slightly larger than the maximum outer diameter of the spring (5) so as to allow the spring (5) to shorten and lengthen during its movement.

In an embodiment of the present invention, the household appliance (1) comprises a touch button (7) having a plate (6) the diameter of which is larger than the diameter of the spring (5). The plate (6) is sized to be approximately same as the designated area (A) for the user to touch. Thus, the capacitive change that is generated when the user moves his/her finger near or touches the designated area (A) can be detected more precisely.

In an embodiment of the present invention, the household appliance (1) comprises a guide (10) the height of which is less than the free height of the spring (5). Thus, a distance remains between the plate (6) and the guide (10) sufficient for the spring (5) to stretch a little, the spring (5) is stretched in the compression direction when the control panel (2) is seated on the plate (6) and the plate (6) is provided to fully contact the control panel (2) by means of the spring (5) that exerts pressure at the lower side.

In an embodiment of the present invention, the guide (10) comprises two support members (9, 109) which form the housing (8), the diameter of which is larger than the diameter of the spring (5) and smaller than the diameter of the plate (6) and which surrounds the spring (5), when joined so as to sandwich the spring (5). Thus, the guide (10) can be disposed from below the plate (6) having a diameter larger than the diameter of the housing (8) such that the spring (5) remains between the two support members (9, 109.)

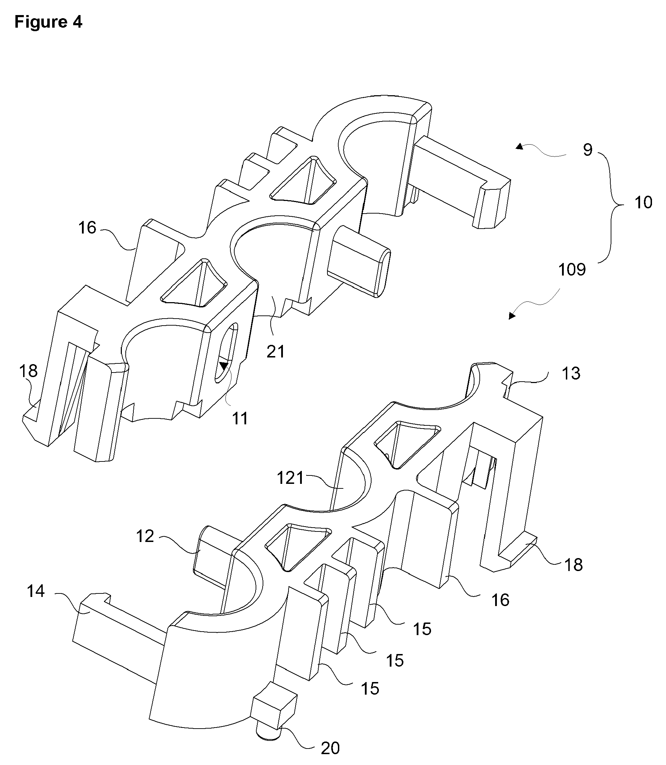

In a derivative of this embodiment, the guide (10) comprises at least one slot (21, 121) arranged on at least one support member (9, 109) and which forms the housing (8) by being aligned with each other (Figure 4).

In another derivative of this embodiment, the guide (10) comprises at least one recess (11) arranged on the first support member (9) and at least one protrusion (12) situated on the second support member (109) and which provides the slots (21, 121) situated on the support members (9, 109) to be aligned with each other by entering into the recess (11) (Figure 4).

In another derivative of this embodiment, the guide (10) comprises at least one resting surface (13) situated on the first support member (9) and at least one fixing member (14) situated on the second support member (109) and which provides the support members (9, 109) to join by bearing against the resting surface (13) (Figure 4).

In another derivative of this embodiment, the household appliance (1) comprises at least one rib (15) situated on the outer surface of the support members (9, 109) and which allows to apply force on the support members (9, 109) during the joining of the first support member (9) and the second support member (109) so as to provide the fixing member (14) to be mounted on the resting surface (13). Thus, the mounting of the support members (9, 109) is facilitated (Figure 4).

In another derivative of this embodiment, the guide (10) comprises at least one handle (16) situated on the outer surface of the support members (9, 109) and which allows the support members (9, 109) to be held during the separation of the first support member (9) from the second support member (109). Thus, the dismounting of the support members (9, 109) can be easily realized (Figure 4).

In a derivative of this embodiment, the household appliance (1) comprises two identical support members (9, 109). Thus, the stock tracking of the support members (9, 109) is facilitated.

In an embodiment of the present invention, the household appliance (1) comprises at least one opening (17) arranged on the circuit board (4) and at least one claw (18) situated on the guide (10) and which provides the guide (10) to be mounted to the circuit board (4) by passing through the opening (17). Thus, the guide (10) is fixed to the circuit board (4) without requiring an additional connection member (Figure 2, Figure 4).

In this embodiment, the household appliance (1) furthermore comprises a hole (19) arranged on the circuit board (4) and at least one pin (20) situated on the guide (10) and which provides the claw (18) to reach the level of the opening (17) by passing through the hole (19). While the guide (10) is being mounted on the circuit board (4), first the pin (20) is inserted into the hole (19) on the circuit board (4), thus aligning the claw (18) so as to pass through the opening (17) (Figure 2, Figure 4).

In different embodiments of the present invention, the household appliance (1) is a laundry dryer, a cooking device, a washing machine, a dishwasher or a cooling device.

The guide (10) which has the housings (8) that surround the springs (5) fixed to the circuit board (4) from one end prevents the springs (5) from being deformed in the horizontal plane and thus provides the capacitive change to be transmitted to the sensor (3) in a reliable manner.

It is to be understood that the present invention is not limited to the embodiments disclosed above and a person skilled in the art can easily introduce different embodiments. These should be considered within the scope of the protection postulated by the claims of the present invention.

## Claims

1. A household appliance (1) comprising
- a control panel (2) having a designated area (A) thereon which provides the user to select the desired program parameters by touching,
- a circuit board (4) having a sensor (39) situated behind the control panel (2) and
- at least one touch button (7) having at least one spring (5) one end of which is fixed to the circuit board (4) and which transmits to the sensor (3) the capacitive difference that is generated when the designated area (A) is touched and a plate (6) which is fixed to the free end of the spring (5) so as to contact the control panel (2), and a guide (19) having a housing (8) that surrounds the spring (5) almost without a gap so as to allow the spring (5) to shorten and lengthen,
**characterized by** the guide (10) having two support members (9, 109) which form the housing (8), the diameter of which is larger than the diameter of the spring (5) and smaller than the diameter of the plate (6) and which surrounds the spring (5) when joined so as to sandwich the spring (5).

2. The household appliance (1) as in Claim 1, **characterized by** the touch button (7) having a plate (6) the diameter of which is larger than the diameter of the spring (5).

3. The household appliance (1) as in any one of the above Claims, **characterized by** a guide (10) the height of which is less than the free height of the spring (5).

4. The household appliance (1) as in any one of the above Claims, **characterized by** the guide (10) that comprises at least one slot (21, 121) situated on at least one support member (9, 109) and which forms the housing (8) by being aligned with each other.

5. The household appliance (1) as in any one of the above Claims, **characterized by** the guide (10) that comprises at least one recess (11) arranged on the first support member (9) and at least one protrusion (12) situated on the second support member (109) and which provides the slots (21, 121) situated on the support members (9, 109) to be aligned with each other by entering into the recess (11).

6. The household appliance (1) as in any one of the above Claims, **characterized by** the guide (10) that comprises at least one resting surface (13) situated on the first support member (9) and at least one fixing member (14) situated on the second support member (109) and which provides the support members (9. 109) to join by bearing against the resting surface (13).

7. The household appliance (1) as in any one of the above Claims, **characterized by** two identical support members (9, 109).

8. The household appliance (1) as in any one of the above Claims, **characterized by** at least one opening (17) arranged on the circuit board (4) and at least one claw (18) situated on the guide (10) and which provides the guide (10) to be mounted to the circuit board (4) by passing through the opening (17).

9. The household appliance (1) as in Claim 8, **characterized by** at least one hole (19) to arranged on the circuit board (4) and at least one pin (20) situated on the guide (10) and which provides the claw (18) to reach the level of the opening (17) by passing through the hole (19).

10. The household appliance (1) as in any one of the Claims 1 to 9, which is a laundry dryer.

11. The household appliance (1) as in any one of the Claims 1 to 9, which is a cooking device.

12. The household appliance (1) as in any one of the Claims 1 to 9, which is a washing machine.

13. The household appliance (1) as in any one of the Claims 1 to 9, which is a dishwasher.

14. The household appliance (1) as in any one of the Claims 1 to 9, which is a cooling device.

## Patentansprüche

1. Haushaltsgerät (1), umfassend
- ein Bedienfeld (2) mit einem ausgewiesenen Bereich (A), der es dem Benutzer ermöglicht, die gewünschten Programmparameter durch Berühren auszuwählen,
- eine Platine (4) mit einem Sensor (3), die hinter dem Bedienfeld (2) angeordnet ist, und
- wenigstens eine Berührungstaste (7) mit wenigstens einer Feder (5), deren eines Ende an der Platine (4) befestigt ist und die die kapazitive Differenz an den Sensor (3) überträgt, die sich bildet, wenn der ausgewiesene Bereich (A) berührt wird, und eine Platte (6), die am freien Ende der Feder (5) angebracht ist, derart, dass sie in Kontakt mit dem Bedienfeld (2) steht, und eine Führung (19) mit einem Gehäuse (8), das die Feder (5) nahezu lückenlos umgibt, derart, dass sich die Feder (5) zusammenziehen und ausdehnen kann,
**dadurch gekennzeichnet, dass** die Führung (10) zwei Stützelemente (9, 109) aufweist, die das Gehäuse (8) bilden und deren Durchmesser größer als der Durchmesser der Feder (5) und kleiner als der Durchmesser der Platte (6) ist und die die Feder (5) umgeben, wenn sie zusammengesetzt sind, derart, dass die Feder (5) zwischen ihnen liegt.

2. Haushaltsgerät (1) nach Anspruch 1, **dadurch gekennzeichnet, dass** die Berührungstaste (7) eine Platte (6) aufweist, deren Durchmesser größer als der Durchmesser der Feder (5) ist.

3. Haushaltsgerät (1) nach einem der vorangehenden Ansprüche, **dadurch gekennzeichnet, dass** die Höhe der Führung (10) geringer als die freie Höhe der Feder (5) ist.

4. Haushaltsgerät (1) nach einem der vorangehenden Ansprüche, **dadurch gekennzeichnet, dass** die Führung (10) wenigstens einen Schlitz (21, 121) umfasst, der an wenigstens einem Stützelement (9, 109) angeordnet ist und durch Ausrichtung aneinander das Gehäuse (8) bildet.

5. Haushaltsgerät (1) nach einem der vorangehenden Ansprüche, **dadurch gekennzeichnet, dass** die Führung (10) wenigstens eine Vertiefung (11), die an dem ersten Stützelement (9) angeordnet ist, und wenigstens einen Vorsprung (12) umfasst, der an dem zweiten Stützelement (109) angeordnet ist und es ermöglicht, dass die Schlitze (21, 121) an den Stützelementen (9, 109) aneinander ausgerichtet werden, indem er in die Vertiefung (11) eintritt.

6. Haushaltsgerät (1) nach einem der vorangehenden Ansprüche, **dadurch gekennzeichnet, dass** die Führung (10) wenigstens eine Anlagefläche (13) an dem ersten Stützelement (9) und wenigstens ein Befestigungselement (14) am zweiten Stützelement (109) umfasst, das es ermöglicht, dass die Stützelemente (9, 109) miteinander verbunden werden, indem es an der Anlagefläche (13) anliegt.

7. Haushaltsgerät (1) nach einem der vorangehenden Ansprüche, **gekennzeichnet durch** zwei identische Stützelemente (9, 109).

8. Haushaltsgerät (1) nach einem der vorangehenden Ansprüche, **gekennzeichnet durch** wenigstens eine Öffnung (17), die an der Platine (4) angeordnet ist, und wenigstens eine Klaue (18), die an der Führung (10) angeordnet ist und es ermöglicht, dass die Führung (10) an der Platine (4) angebracht wird, indem sie **durch** die Öffnung (17) tritt.

9. Haushaltsgerät (1) nach Anspruch 8, **gekennzeichnet durch** wenigstens eine Bohrung (19), die an der Platine (4) angeordnet ist, und wenigstens einen Stift (20), der an der Führung (10) angeordnet ist und es ermöglicht, dass die Klaue (18) die Höhe der Öffnung (17) erreicht, indem er **durch** die Bohrung (19) tritt.

10. Haushaltsgerät (1) nach einem der vorangehenden Ansprüche 1 bis 9, das ein Wäschetrockner ist.

11. Haushaltsgerät (1) nach einem der vorangehenden Ansprüche 1 bis 9, das eine Kochvorrichtung ist.

12. Haushaltsgerät (1) nach einem der vorangehenden Ansprüche 1 bis 9, das eine Waschmaschine ist.

13. Haushaltsgerät (1) nach einem der Ansprüche 1 bis 9, das ein Geschirrspüler ist.

14. Haushaltsgerät (1) nach einem der vorangehenden Ansprüche 1 bis 9, das eine Kühlvorrichtung ist.

## Revendications

1. Un électroménager (1) comprenant :
- un panneau de commande (2) qui présente une zone désignée (A), qui permet à l'utilisateur de sélectionner les paramètres de programmes souhaités en la touchant,
- une carte de circuit (4) qui présente un capteur (3) disposé derrière le panneau de commande (2), et
- au moins un bouton tactile (7) qui présente au moins un ressort (5) dont une extrémité est fixée à la carte de circuit (4) et qui transmit au capteur (3) la différence capacitive générée lorsque la zone désignée (A) est touchée et une plaque (6) qui est fixée à l'extrémité libre du ressort (5) de manière à toucher le panneau de commande (2), et un guide (19) présentant un logement (8) qui entoure le ressort (5) presque sans un espace de manière à permettre au ressort (5) de se raccourcir et s'allonger,
**caractérisé par** le guide (10) présentant deux éléments de support (9, 109) qui forment le logement (8), le diamètre duquel est supérieur au diamètre du ressort (5) et inférieur au diamètre de la plaque (6), et qui entoure le ressort (5) lorsqu'il est joint de manière à prendre en sandwich le ressort (5).

2. Un électroménager (1) selon la Revendication 1, **caractérisé par** le bouton tactile (7) qui présente une plaque (6) dont le diamètre est supérieur au diamètre du ressort (5).

3. Un électroménager (1) selon l'une quelconque des revendications précédentes, **caractérisé par** un guide (10) dont la hauteur est inférieure à la hauteur libre du ressort (5).

4. Un électroménager (1) selon l'une quelconque des revendications précédentes, **caractérisé par** le guide (10) comprenant au moins une fente (21, 121) qui est située sur au moins un élément de support (9, 109) et qui forme le logement (8) en s'alignant l'une avec l'autre.

5. Un électroménager (1) selon l'une quelconque des revendications précédentes, **caractérisé par** le guide (10) comprenant au moins un évidement (11) qui est situé sur le premier élément de support (9) et au moins une protubérance (12) qui est situé sur le deuxième élément de support (109) et qui permet aux fentes (21, 121) situées sur les éléments de support (9, 109) d'être alignées l'une avec l'autre en entrant dans l'évidement (11).

6. Un électroménager (1) selon l'une quelconque des revendications précédentes, **caractérisé par** le guide (10) comprenant au moins une surface d'appui (13) qui est située sur le premier élément de support (9) et au moins un élément de fixation (14) qui est situé sur le deuxième élément de support (109) et qui permet aux éléments de support (9, 109) de se joindre en s'appuyant sur la surface d'appui (13).

7. Un électroménager (1) selon l'une quelconque des revendications précédentes, **caractérisé par** deux éléments de support identiques (9, 109).

8. Un électroménager (1) selon l'une quelconque des revendications précédentes, **caractérisé par** au moins une ouverture (17) qui est arrangée sur la carte de circuit (4) et au moins un crochet (18) qui est situé sur le guide (10) et qui permet au guide (10) d'être monté sur la carte de circuit (4) en passant à travers l'ouverture (17).

9. Un électroménager (1) selon la Revendication 8, **caractérisé par** au moins un trou (19) qui est arrangé sur la carte de circuit (4) et au moins une goupille (20) qui est située sur le guide (10) et qui permet au crochet (18) d'atteindre le niveau de l'ouverture (17) en passant à travers le trou (19).

10. Un électroménager (1) selon l'une quelconque des revendications de 1 à 9, qui est un sèche-linge.

11. Un électroménager (1) selon l'une quelconque des revendications de 1 à 9, qui est un dispositif de cuisson.

12. Un électroménager (1) selon l'une quelconque des revendications de 1 à 9, qui est une lave-linge.

13. Un électroménager (1) selon l'une quelconque des revendications de 1 à 9, qui est un lave-vaisselle.

14. Un électroménager (1) selon l'une quelconque des revendications de 1 à 9, qui est un dispositif de refroidissement.
